(19) Europäisches Patentamt
European Patent Office
Office européen des brevets

(11) **EP 2 363 719 A1**

(12) **EUROPEAN PATENT APPLICATION**

(43) Date of publication:
**07.09.2011 Bulletin 2011/36**

(51) Int Cl.:
*G01R 27/32* (2006.01)  *G01R 35/00* (2006.01)

(21) Application number: **11153600.9**

(22) Date of filing: **07.02.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **12.02.2010 US 303883 P**

(71) Applicant: **ATE Systems, Inc**
**North Billerica, MA 01862 (US)**

(72) Inventors:
• **Adamian, Vahé**
  **Westlake Village, CA 91362 (US)**
• **Phillips, Peter**
  **Leominster, MA 01453 (US)**

(74) Representative: **Benson, Christopher**
**Harrison Goddard Foote**
**Fountain Precinct**
**Balm Green**
**Sheffield, South Yorkshire S1 2JA (GB)**

(54) **Method and apparatus for calibrating a test system for measuring a device under test**

(57)    Methods and apparatus for calibrating a vector network analyzer (VNA) and characterizing a device under test. In one example, a device fixture (110) including a pair of embedded device adapters (150,155) provides an interface between a device under test (DUT) with non-coaxial connectors and the coaxial connectors of the VNA (170), and moves the calibration reference plane from the coaxial connectors of the VNA to a DUT reference plane (190a,190b) at the leads/connectors of the DUT. A through fixture (510) having a pair of similar through adapters (520,525) is used to establish the DUT reference plane and to facilitate characterizing the device adapters such that they can be de-embedded from measurements of the device fixture.

Figure 1

**EP 2 363 719 A1**

**Description**

1. Field of Invention

The present invention relates to methods and apparatus for calibrating a vector network analyzer and characterizing a device under test on the network analyzer.

2. Discussion of Related Art

It is known that errors exist in a measurement made by a Vector Network Analyzer (VNA). These measurement errors contribute to the uncertainty of the result given by the measurement of a device under test ("DUT"). The measurement errors may be categorized into two types, random errors and systematic errors. Random errors are non-repeatable variations of the same measurement due to physical and environmental changes over time. Systematic errors are repeatable variations in the measurement as a result of the VNA test set. Typically, the systematic errors represent the larger contribution to measurement uncertainty. It is possible to mathematically reduce the systematic errors in a VNA measurement through calibration. Calibration comprises connecting a number of well-known standards to the VNA and measuring the response for each of the well-known standards. The systematic errors are quantified by calculating the difference between the measured response and the expected response for each of the well-known standards. This difference is used to develop an error correction model that may be used to mathematically remove systematic errors from a VNA measurement of the DUT. The calibration process effectively establishes a measurement reference plane at the point where the calibration standards are connected to the VNA measurement ports. Accordingly, it is possible to obtain a measurement of just the DUT by connecting the DUT to the measurement reference plane.

There are several different calibration methods that use calibration standards traceable to the National Institute of Standards Technology (NIST). As those skilled in the art can appreciate, the quality of the error correction achieved through calibration is directly related to the quality of the calibration standards used. Most traceable calibration standards are made with coaxial connectors; however, presently many devices either in a production or research environment do not have a coaxial connection. U.S. Patent No. 7,157,918 entitled "Method and System For Calibrating a Measurement Device Path and For Measuring a Device Under Test in the Calibrated Measurement Path" issued on January 2, 2007 (hereinafter "the '918 patent") discloses a method of calibrating connections to non-coaxial devices under test. In particular, the '918 patent presents a method to characterize a DUT where the calibration reference plane is different from the DUT reference plane. The '918 patent describes a method to characterize a pair of adapters embedded between the calibration reference plane and DUT reference plane. Once the adapters are known, the DUT can be characterized by using a de-embedding algorithm.

SUMMARY OF THE INVENTION

Aspects and embodiments are directed to methods and apparatus for calibrating a vector network analyzer (VNA) and characterizing a device under test. According to one embodiment, a device fixture including a pair of embedded device adapters is used to provide an interface between a device under test (DUT) with non-coaxial connectors and the coaxial connectors of the VNA, and to move the calibration reference plane from the coaxial connectors of the VNA to a DUT reference plane at the leads/connectors of the DUT. A through fixture having a pair of similar through adapters is used to establish the DUT reference plane and to facilitate characterizing the device adapters such that they can be de-embedded from measurements of the device fixture, as discussed below.

One embodiment of a method of calibrating first and second device adapters for a vector network analyzer is disclosed. The method comprises connecting a through circuit path to at least a first calibrated coaxial port of a vector network analyzer and calculating first S-parameters of each of the first and second through adapters. The through circuit path comprises a cascaded combination of first and second through adapters. The method also comprises connecting a measurement circuit path between the first calibrated coaxial port and a second calibrated coaxial port of the vector network analyzer, the measurement path comprising a cascaded combination of a device under test and the first and second device adapters. The method further comprises determining second S-parameters of the measurement circuit path, and characterizing the first and second device adapters based upon the first and second S-parameters.

Another embodiment of a method of calibrating first and second device adapters for a vector network analyzer comprises connecting a through circuit path between first and second calibrated coaxial ports of a vector network analyzer and calculating first S-parameters of each of the first and second through adapters,. The through circuit path comprises a cascaded combination of first and second through adapters. The method also comprises connecting a measurement circuit path between the first and second calibrated coaxial ports, wherein the measurement path comprising a cascaded combination of a device under test and the first and second device adapters. The method further comprises measuring second S-parameters of the measurement circuit path, calculating corrected S-parameters of the measurement circuit path using the first S-parameters, and based on the corrected S-parameters, determining corrected S-parameters of the first and second device adapters.

Another embodiment of a method of calibrating first and second device adapters comprises calibrating first and second coaxial ports of a vector network analyzer to traceable standards, and connecting a through circuit path between the first and second coaxial ports. The through circuit path comprises a cascaded combination of first and second through adapters. The method further comprises calculating first S-parameters of each of the first and second through adapters, and connecting a measurement circuit path between the first and second coaxial ports. The measurement circuit path comprises a cascaded combination of a device under test and the first and second device adapters. The method further comprises measuring second S-parameters of the measurement circuit path, and characterizing the first and second device adapters based upon the first and second S-parameters.

Still another embodiment of a method of characterizing a device under test comprises calibrating first and second coaxial ports of a vector network analyzer to traceable standards, and connecting a through circuit path between the first and second coaxial ports. The through circuit path comprises a cascaded combination of first and second through adapters. The method also comprises calculating first S-parameters of each of the first and second through adapters, and connecting a measurement circuit path between the first and second coaxial ports. The measurement path comprises a cascaded combination of the device under test and first and second device adapters. The method further comprises calculating second S-parameters of the measurement circuit path, determining third S-parameters of the first and second device adapters based upon the first and second S-parameters; and characterizing the device under test based upon the second and third S-parameters.

Aspects of any of the methods disclosed include calibrating first and second coaxial ports of the vector network analyzer to traceable standards to provide the first and second calibrated coaxial ports of the vector network analyzer, , prior to connecting the through circuit path.

Aspects of any of the methods discclosed include calculating the first S-parameters by determining overall S-parameters of the through circuit path, including an overall transmission parameter, an overall input reflection parameter, and an overall output reflection parameter.

Aspects of any of the methods disclosed include determining the overall S-parameters, connecting a calibration standard to an output port of the first through adapter; and measuring reflection coefficients of the through circuit path.

Aspects of any of the methods disclosed include connecting the calibration standard including at least three calibration standards and measuring reflection coefficients corresponding to each of the at least three calibration standards. The method further comprises connecting the at least three calibration standards including a short standard, an open standard, and a load standard.

Aspects of any of the methods disclosed include calculating the first S-parameters by determining an electrical delay of the through circuit path.

Aspects of any of the methods disclosed include determining the electrical delay by converting the overall transmission parameter from frequency-domain into a time-domain impulse response.

Aspects of any of the methods disclosed include converting the overall input reflection parameter from the frequency-domain into an input time-domain impulse response, gating the input time-domain impulse response by the electrical delay, and reconstructing a frequency-domain gated input reflection parameter corresponding to a first input reflection parameter of the first through adapter.

Aspects of any of the methods disclosed include converting the overall output reflection parameter from the frequency-domain into an output time-domain impulse response, gating the output time-domain impulse response by the electrical delay, and reconstructing a frequency-domain gated output reflection parameter corresponding to a first output reflection parameter of the second through adapter.

Aspects of any of the methods disclosed include calculating remaining first S-parameters of the first and second through adapters based on the first input reflection parameter and the first output reflection parameter.

A system for calibrating a device measurement path is also disclosed. One embodiment of the system comprises a vector network analyzer having at least a first port and a second port, and a fixture including a through path and the device measurement path. The through path includes a cascaded combination of first and second through adapters, and the device measurement path including first and second device adapters and a mounting area disposed between the first and second device adapters and configured to receive a device under test. The vector network analyzer is configured to measure frequency domain responses of the through measurement path and calculate first S-parameters of each of the first and second through adapters. The vector network analyzer is also configured to measure frequency domain responses of the device measurement path, to calculate second S-parameters of the device measurement path, and to calibrate the device measurement path based on the first and second S-parameters.

Aspects of the system disclosed herein include calibration standards, wherein the vector network analyzer is further configured to calibrate the first and second ports with the calibration standards.

Aspects of the system disclosed herein include that the vector network analyzer is configured to convert the frequency domain responses to corresponding time domain responses to calculate the first and second S-parameters.

Aspects of the system disclosed herein include that the frequency domain responses of the through circuit include a frequency domain transmission response, a frequency domain input reflection response, and a frequency domain output reflection response, and that the vector network analyzer is further configured to convert the frequency domain transmission response to a time domain transmission response and to extract an electrical length of the through path from the time domain transmission response.

Aspects of the system disclosed herein include that the vector network analyzer is further configured to convert the frequency domain input reflection response into a time domain input reflection response, convert the frequency domain output reflection response into a time domain output reflection response, gate the time domain input and output reflection responses based on the electrical length of the through path, reconstruct a frequency-domain gated input reflection parameter of the first through adapter; and reconstruct a frequency-domain gated output reflection parameter of the second through adapter.

A computer readable medium having stored thereon sequences of instruction for calibrating a device measurement path of a fixture is also disclosed. An embodiment of the non-transitory computer readable medium includes instructions that will cause at least one processor to prompt a user to connect a through circuit path of the fixture to a calibrated coaxial port of a vector network analyzer and calculate first S-parameters of each of a first and second through adapter included in the through circuit path. The non-transitory computer readable medium also includes instructions that will prompt the user to connect the device measurement path between calibrated coaxial ports of the vector network analyzer, calculate second S-parameters of each of a first and second device adapter included in the device measurement path, and calibrate the first and second device adapters based on the first and second S-parameters.

Still other aspects, embodiments, and advantages of these exemplary aspects and embodiments, are discussed in detail below. Any embodiment disclosed herein may be combined with any other embodiment in any manner consistent with at least one of the objects, aims, and needs disclosed herein, and references to "an embodiment," "some embodiments," "an alternate embodiment," "various embodiments," "one embodiment" or the like are not necessarily mutually exclusive and are intended to indicate that a particular feature, structure, or characteristic described in connection with the embodiment may be included in at least one embodiment. The appearances of such terms herein are not necessarily all referring to the same embodiment. The accompanying drawings are included to provide illustration and a further understanding of the various aspects and embodiments, and are incorporated in and constitute a part of this specification. The drawings, together with the remainder of the specification, serve to explain principles and operations of the described and claimed aspects and embodiments.

BRIEF DESCRIPTION OF THE DRAWINGS

Various aspects of at least one embodiment are discussed below with reference to the accompanying figures, which are not intended to be drawn to scale. Where technical features in the figures, detailed description or any claim are followed by references signs, the reference signs have been included for the sole purpose of increasing the intelligibility of the figures, detailed description, and claims. Accordingly, neither the reference signs nor their absence are intended to have any limiting effect on the scope of any claim elements. In the figures, each identical or nearly identical component that is illustrated in various figures is represented by a like numeral. For purposes of clarity, not every component may be labeled in every figure. The figures are provided for the purposes of illustration and explanation and are not intended as a definition of the limits of the invention. In the figures:

FIG. 1 is a schematic diagram of a device under test connected to a vector network analyzer, according to aspects of the invention;

FIG. 2 is a flow diagram illustrating one example of a calibration method and method of characterizing a device under test according to aspects of the invention;

FIG. 3 is a block diagram of one example of a vector network analyzer with a first port coupled to a calibration standard;

FIG. 4 is a block diagram of one example of a vector network analyzer with a second port coupled to a calibration standard;

FIG. 5 is a block diagram of one example of a through fixture coupled to a vector network analyzer, according to aspects of the invention;

FIG. 6 is a block diagram of an example of a fixture, incorporating both a through fixture and a device fixture, coupled to a vector network analyzer according to aspects of the invention;

FIG. 7 is a block diagram and flow graph illustrating the S-parameters of one example of a through fixture according to aspects of the invention;

FIG. 8A is a flow diagram of one example of a process of calculating S-parameters of the through fixture according to aspects of the invention;

FIG. 8B is a flow diagram of one example of a process of calculating an input reflection parameter of a through adapter according to aspects of the invention;

FIG. 8C is a flow diagram of one example of a process of calculating an output reflection parameter of a through adapter according to aspects of the invention;

FIG. 9 is a block diagram of one example of a through fixture connected in a through configuration between two ports of a vector network analyzer according to aspects of the invention;

FIG. 10 is a flow diagram of one example of a process of calculating S-parameters of the device fixture according to aspects of the invention; and

FIG. 11 is a flow diagram of one example of a process of calculating corrected reflection parameters of the device adapters according to aspects of the invention.

DETAILED DESCRIPTION

Vector network analyzers (VNAs) are used to measure various parameters and characteristics of a wide variety of devices; however, as discussed above, most network analyzers have ports with coaxial connectors and are calibrated to coaxially connected standards, whereas many modem devices do not have coaxial connectors. Accordingly, aspects and embodiments are directed to methods and apparatus for calibrating a vector network analyzer to the reference plane of a device under test (DUT) where the DUT has non-coaxial connectors. At least one embodiment uses a DUT fixture that includes a pair of embedding adapters configured to provide an interface between the calibrated coaxial VNA reference plane and the non-coaxial DUT reference plane, as discussed in more detail below.

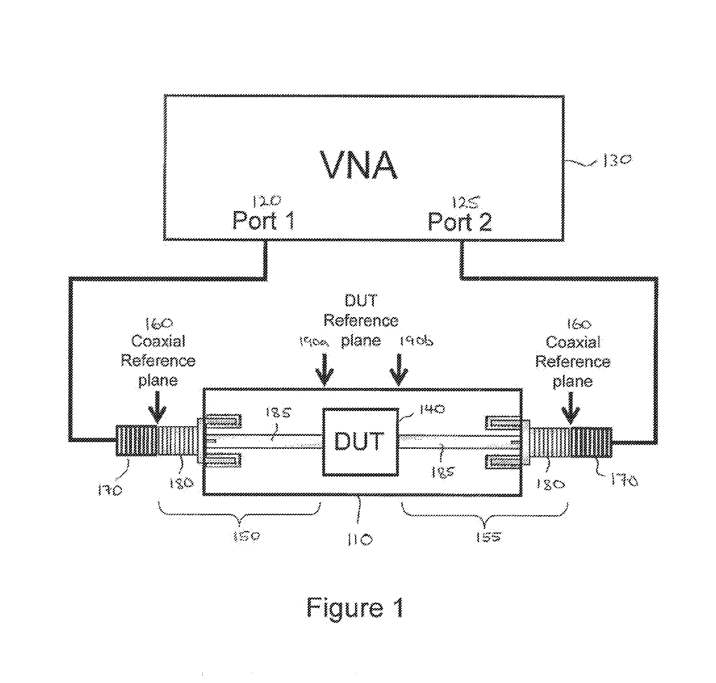

Referring to FIG. 1 there is illustrated an example of a device under test (DUT) fixture 110 connected to a first port 120 and a second port 125 of a vector network analyzer (VNA) 130. The DUT fixture 110 includes a DUT 140, a first device adapter 150 and a second device adapter 155. Each device adapter 150, 155 includes a coaxial connector 180 and a transmission line 185. The coaxial reference plane 160 of the VNA 130 is between the coaxial connectors 170 on the ports of the VNA 130 and the coaxial connectors 180 on the DUT fixture 110. The DUT reference plane is indicated by arrows 190a, 190b, as shown in FIG.1. The device adapters 150, 155 provide an interface between the DUT reference plane and the coaxial reference plane 160. In one embodiment, the first device adapter 150 forms the input section of the DUT fixture 110 and includes the circuit from the coaxial reference plane 160 to the DUT input reference plane 190a, and the second device adapter 155 forms the output section of the DUT fixture 110 including the circuit from the DUT output reference plane 190b to the coaxial reference plane 160. As discussed in more detail below, the device adapters 150, 155 are configured to allow reliable calibration to the DUT reference planes 190a, 190b while accommodating a wide variety of device types and device package configurations.

As discussed above, U.S. Patent No. 7,157,918 (the '918 patent) discloses a method of calibrating connections to non-coaxial devices using fixtures including two pairs of embedding adapters, namely a pair of adapters in a DUT configuration and a pair of adapters in a "through" configuration. The method described in the '918 patent is ideal for devices such as high frequency transistors or surface-mount topologies with non-coaxial connectors that are embedded in a fixture where the transmission line between the coaxial calibration reference plane and non-coaxial DUT reference plane is electrically very short. However, the method disclosed in the '918 patent relies on assumptions and imposes hardware constraints on the pairs of adapters that introduce significant calibration error into the measurement of DUT when the adapter pairs are electrically long. Specifically, in order to characterize the pair of adapters in the DUT configuration using the method described in the '918 patent, the overall S-parameters of the adapters, cascaded together, are measured in a through configuration between ports of the vector network analyzer, and the following conditions must be met: 1) the two adapters in each pair (DUT configuration and through configuration) must be mirror images of one another; and 2) the characteristics of each adapter between the through configuration and the DUT configuration are assumed to be substantially equivalent. Although the '918 patent provides an improvement over traditional "on-board" calibration standards, these two requirements introduce significant error into the measurement of a DUT when the adapter pairs are electrically long. This error results from the symmetry condition imposed on each the pair of adapters discussed above. In particular, the mirror image symmetry of reflection parameters between the two adapters of the pair becomes impossible to maintain in the hardware design of the fixture when the transmission line is electrically long. Also, the characteristics of the through adapters and the device adapters cannot be assumed to be equivalent, as required by the method of the '918 patent.

In a complex automatic test station where vector, spectrum, noise, power and other performance parameters need to be characterized with a single connection, it becomes impossible to design a fixture with electrically short transmission lines between the coaxial calibration reference plane and non-coaxial DUT reference plane. This is due to the need for multiple apparatus to be connected to a single device to perform a number of measurements. For example, the DUT input and outputs are not always in the same plane; one DUT can have the input and output on the same side of the package, whereas the next can have the input and output on opposing sides. In addition, many different package sizes and types may be measured on the same fixture base, requiring a great flexibility with the input and output traces. Accordingly, there is a need for an improved method and system for calibrating and measuring high frequency non-coaxial devices where plurality of performance parameters can be measured with a single device connection while deploying a wide variety of fixtures that are not limited to having electrically short transmission lines.

Aspects and embodiments are directed to methods and apparatus for calibrating a vector network analyzer to the reference plane of a device under test (DUT) where the DUT has non-coaxial connectors. In one embodiment, calibration is achieved using a DUT fixture 110 that includes a first pair of device adapters 150, 155 (as shown in FIG. 1) to move the calibration reference plane to the DUT reference plane, and a through fixture that includes a second pair of similar through adapters used to establish the DUT reference plane, as discussed in more detail below. Unlike the method disclosed in the '918 patent, the adapters in each pair are not required to be mirror images of one another. Furthermore, it is recognized that certain characteristics of the adapters may vary from the through adapters to the device adapters, and embodiments of the methods according to aspects of the invention accommodate these variations. Thus, also unlike the method disclosed in the '918 patent, the characteristics of the through adapters and the device adapters are not assumed to be substantially equivalent. Accordingly, the DUT fixture may use device adapters 150, 155 that are electrically long, and can therefore accommodate a wide variety of device types and device package configurations.

It is to be appreciated that embodiments of the methods and apparatuses discussed herein are not limited in application to the details of construction and the arrangement of components set forth in the following description or illustrated in the accompanying drawings. The methods and apparatuses are capable of implementation in other embodiments and of being practiced or of being carried out in various ways. Examples of specific implementations are provided herein for illustrative purposes only and are not intended to be limiting. In particular, acts, elements and features discussed in connection with any one or more embodiments are not intended to be excluded from a similar role in any other embodiments.

Also, the phraseology and terminology used herein is for the purpose of description and should not be regarded as limiting. Any references to embodiments or elements or acts of the systems and methods herein referred to in the singular may also embrace embodiments including a plurality of these elements, and any references in plural to any embodiment or element or act herein may also embrace embodiments including only a single element. References in the singular or plural form are not intended to limit the presently disclosed systems or methods, their components, acts, or elements. The use herein of "including," "comprising," "having," "containing," "involving," and variations thereof is meant to encompass the items listed thereafter and equivalents thereof as well as additional items. References to "or" may be construed as inclusive so that any terms described using "or" may indicate any of a single, more than one, and all of the described terms. Any references to front and back, left and right, top and bottom, upper and lower, and vertical and horizontal are intended for convenience of description, not to limit the present systems and methods or their components to any one positional or spatial orientation.

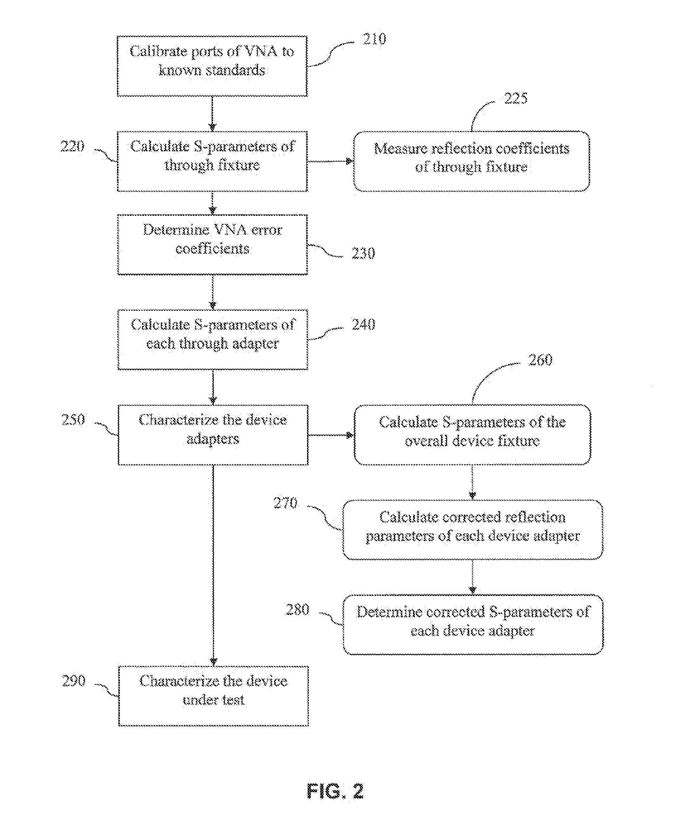

Referring to FIG. 2 there is illustrated a flow diagram of one example of a calibration method and method of characterizing a device under test according to one embodiment. Aspects and embodiments of the method are discussed below with continuing reference to FIG. 2.

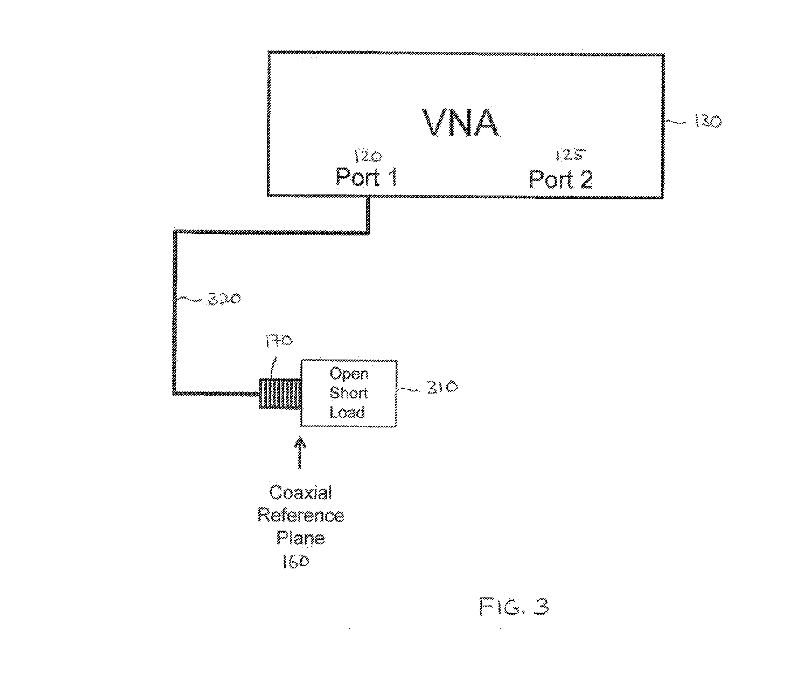

According to one embodiment, a calibration method includes calibrating the ports of the vector network analyzer to known, preferably NIST-traceable, standards (step 210). In order to determine the one-port systematic error coefficients of the first port 120 of the vector network analyzer 130, this calibration step 210 may include connecting a minimum of three known standards 310, such as, for example, an open standard, a short standard, and a load standard, one at a time at the end of a cable 320 connected to the first port 120 of the vector network analyzer, as show in FIG. 3. This calibrates the first port 120 of the vector network analyzer 130 to the coaxial reference plane 160. The short, open and load standards 310 may be separate physical devices, or may be included in an electronic calibration unit. Defining $\Gamma mi$ as the uncorrected reflection coefficient measurements made by the vector network analyzer 130, and defining $\Gamma ai$ as the actual reflection coefficients of the standards 130, then the three one-port systematic error coefficients, referred to as directivity (Dr), source match (Sm) and reflection tracking (Rt), can be determined from Equation (1):

$$\Gamma mi = Dr + Rt\frac{\Gamma ai}{1 - Sm\Gamma ai}; \quad i = 1, 2 \text{ and } 3 \qquad (1)$$

In Equation (1), $i = 1$ corresponds to the open standard, $i = 2$ corresponds to the short standard, and $i = 3$ corresponds to the load standard. Taking the measurements $\Gamma mi$ for each of the three standards provides three versions of Equation (1), which can be solved for the three one-port systematic error coefficients, Dr, Sm and Rt, for the first port 120.

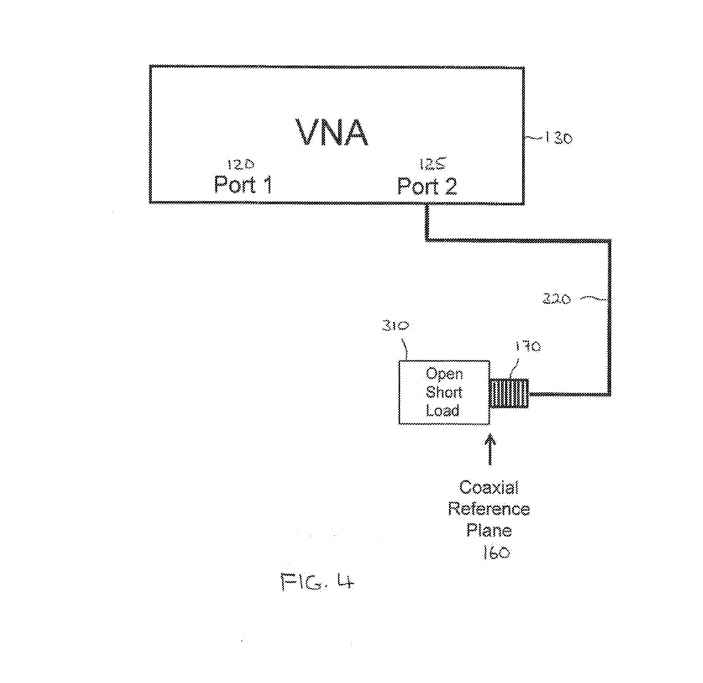

This procedure 210 may be repeated for the second port 125, as illustrated in FIG. 4, as well as for any additional ports (not shown) of a multi-port vector network analyzer. Thus, the one-port systematic error coefficients for the second port 125 of the vector network analyzer 130 are exactly deduced by using the same procedure discussed above and Equation (1). Specifically, directivity, source match and reflection tracking of the second port 125 of the vector network analyzer 130 are determined by connecting a minimum of three known standards 310, such as an open, short and load, at the end of the cable 320 connected to the second port 125 of the vector network analyzer 130. This procedure establishes the coaxial reference plane 160 shown in FIG. 4.

As discussed above, the DUT fixture 110 includes two device adapters 150, 155 which are configured to move the calibration reference plane to the DUT reference plane. In order to measure the S-parameters of the DUT 140, the device adapters 150, 155 have to be characterized. This can be achieved using a through fixture that includes a pair of through adapters similar to the device adapters to establish the DUT reference plane. However, the through adapters of the through fixture are not physically the same circuit as the device adapters of the DUT fixture 110. Accordingly, in one embodiment, a calibration procedure includes characterizing the through adapters and using the resulting data to characterize the device adapters, as discussed in more detail below.

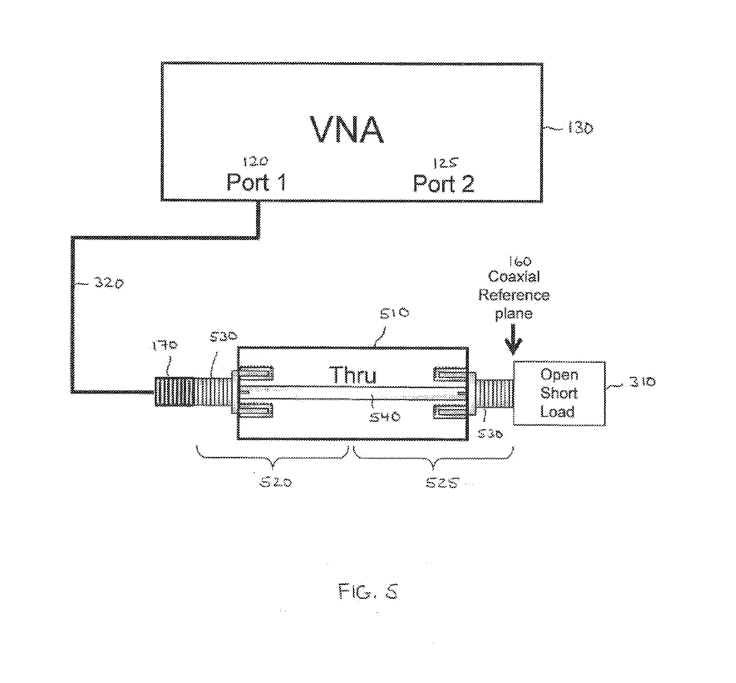

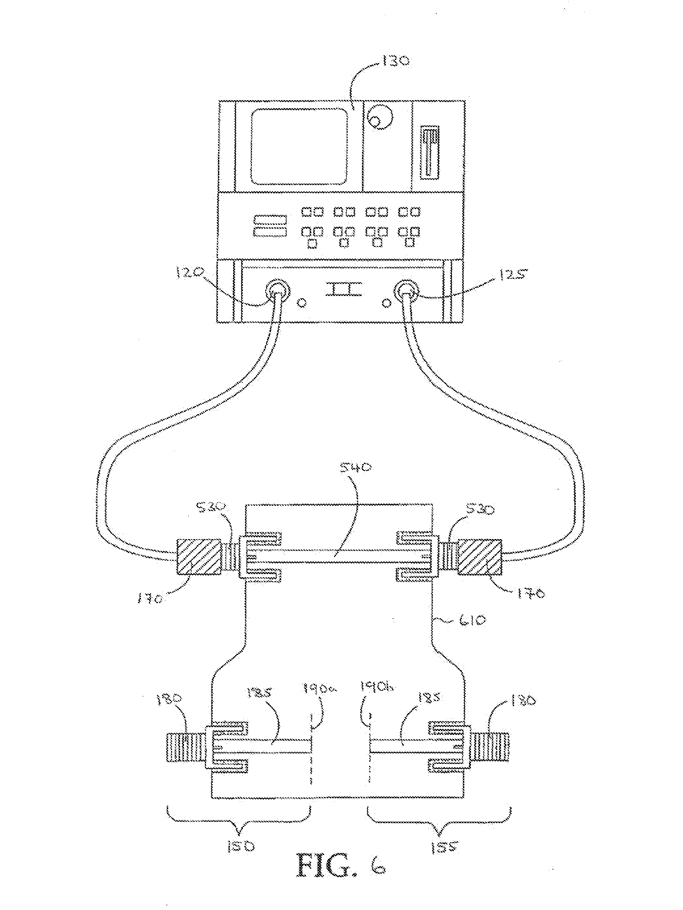

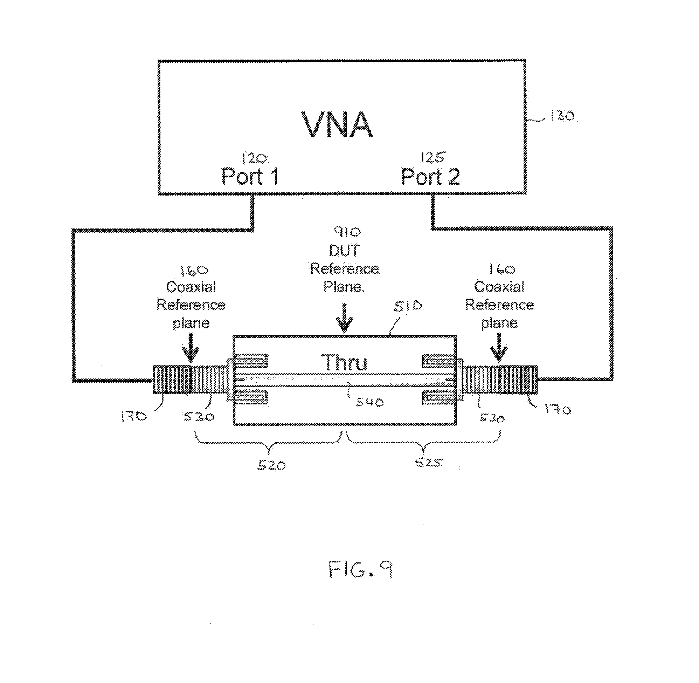

Referring to FIG. 5, there is illustrated a block diagram of the through fixture 510 connected in a through configuration between the first and second ports 120, 125 of the vector network analyzer 130. A first through adapter 520 cascaded with a second through adapter 525 make up the through fixture 510. Each through adapter 520, 525 includes a coaxial connector 530 that connects to the coaxial reference plane 160 of the calibrated vector network analyzer ports and a section of transmission line 540. It is to be appreciated that the through fixture 510 and the DUT fixture 110 may be separate physical devices or may be different paths within the same physical structure 610, as illustrated for example in FIG. 6. In one embodiment, the input and output DUT reference planes 190a, 190b are in the middle of through fixture 510 and they are overlapped in the same reference plane 910 (illustrated in FIG. 9). The cascaded S-parameters of the through adapters 520, 525 of the through fixture 510 can be characterized (step 220) from corrected VNA one-port reflection measurements (obtained in step 210) because of reciprocity of the through fixture 510.

According to one embodiment, the calibration step 220 of characterizing the through fixture 510 includes a step 225 of measuring reflection coefficients of the through fixture. This step 225 may include connecting an input port of the first through adapter 520 of the through fixture 510 to the calibrated first port 120 of the vector network analyzer 130, and connecting an output port of the second through adapter 525 to a minimum of three known standards 310, as shown in FIG. 5. It is to be appreciated that because of reciprocity of the through fixture 510, the reflection coefficients may alternatively be measured by connecting an input port of the second through adapter 525 to the calibrated second port 125 of the vector network analyzer 130, and connecting an output port of the first through adapter 520 to the standards 310. As shown in FIG. 5, the standards 310 are connected to the through fixture 510 at the coaxial reference plane 160. In one example, open, short and load standards are used in step 220 of calibration.

For each standard 310 connected to the coaxial reference plane 160, the vector network analyzer 130 makes a reflection coefficient measurement defined as $Ymi$ (step 225) Since the systematic error coefficients Dr, Sm and Rt are known from Equation (1), as discussed above, the three input reflection coefficients of the through fixture 310, defined as $\Gamma 11i$, terminated in each of the three standards is given by:

$$\Gamma 11i = \frac{Dr - Ymi}{DrSm - YmiSm - Rt}; \quad i = 1, 2, \text{ and } 3 \tag{2}$$

In Equation (2), $i = 1$ corresponds to the open standard, $i = 2$ corresponds to the short standard, and $i = 3$ corresponds to the load standard. The S-parameters of the through fixture 510 can be calculated from $\Gamma ai$, the actual reflection coefficients of the standards 310, and Equation (2). The through fixture S-parameters are given by:

$$\Gamma 11i = S_{T11} + \frac{S_{T11}S_{T21}\Gamma ai}{1 - S_{T22}\Gamma ai}; \quad i = 1, 2 \text{ and } 3 \tag{3}$$

Due to reciprocity, $S_{T12} = S_{T2}$, and therefore, the $S_{12}S_{21} = S_{12}^2$ or $S_{21}^2$. There are two solutions to the square root of a complex variable. These two solutions are 180 degrees out of phase with each other. The correct solution is the one where the extrapolated phase at DC approaches zero degrees. The through fixture 510 thus may be characterized in terms of its overall S-parameters, $S_{T11}$, $S_{T12}$, $S_{T21}$, and $S_{T22}$.

According to one embodiment, the 12-term systematic error coefficients of the vector network analyzer 130 can be determined (step 230) in accord with the procedure described in "An Analysis of Vector Measurement Accuracy," Douglas Rytting, Hewlett-Packard Technical Seminar, May 1986 (which is herein incorporated by reference in its entirety), using the characterized through fixture 510 connected as a through standard between the first and second ports 120, 125 of the vector network analyzer 130, as shown in FIG. 9, and using the one-port VNA measurements from step 210 discussed above with reference to FIGS. 3 and 4.

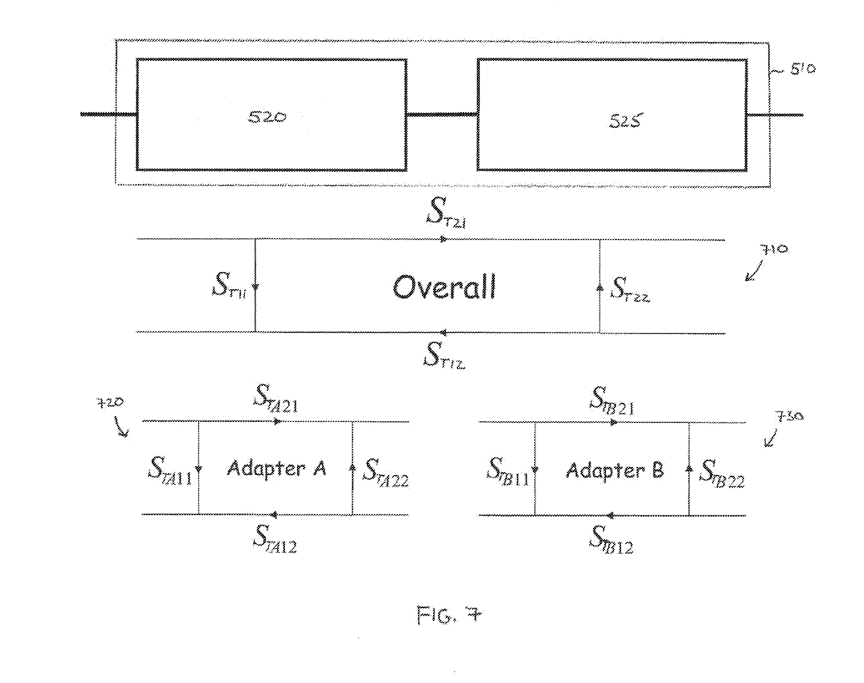

According to one embodiment, after the overall S-parameters of the through fixture 510 have been calculated, the individual through adapters 520, 525 can be characterized (step 240). Referring to FIG. 7, there is illustrated a block diagram of the through fixture 510 (a cascade of the first and second through adapters 520, 525) with its corresponding overall flow graph 710 and the flow graphs 720, 730 of each through adapter. The through fixture 510 is reciprocal (passive), therefore $S_{TA12} = S_{TA21}$ and $S_{TB12} = S_{TB21}$ where subscript "TA" refers to the first through adapter 520 and subscript "TB" refers to the second through adapter 525. In one embodiment, the through fixture hardware is designed such that $S_{TA12}$ or $S_{TA21}$ is equal to $S_{TB12}$ or $S_{TB21}$. Thus, the transmission parameters of the two through adaptors are the same; however the reflection parameters may not be, and the two through adaptors are therefore not required to be mirror images of one another. Maintaining substantially the same transmission coefficient parameter in hardware design between the two through adapters is much simpler, from a technical standpoint, than maintaining substantially the same reflection coefficient between the two adapters.

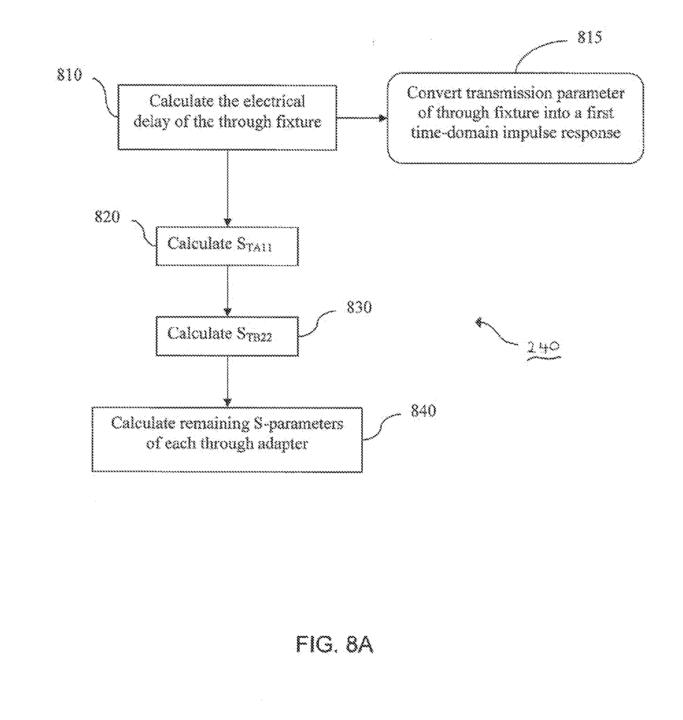

As discussed above, the overall S-parameters of the first through adapter 520 cascaded with the second through adapter 525 (i.e., the S-parameters of the overall through fixture 510) are deduced from Equation (3). FIG. 8A illustrates a flow diagram of one example of a calibration method to determine the S-parameters of each through adapter by itself (corresponding to step 240 in FIG. 2). In a first step 810, the electrical delay of the through fixture 510 is calculated. In one example, the overall transmission parameter, $S_{T21}$, of the through fixture 510 is converted from the frequency-domain into a first time-domain impulse response (step 815). The first time-domain impulse response precisely calculates the electrical delay of the through fixture 510. In one example, the conversion of the overall transmission parameter of the through fixture from the frequency-domain into the time-domain impulse response is accomplished using a chirp z-transform algorithm, as discussed in L.W Rabiner, R. Schafer, "The Chirp z-Transform Algorithm", IEEE Transaction on Audio and Electroacoustics, Vol. AU-17, No. 2, June 1969, which is herein incorporated by reference in its entirety.

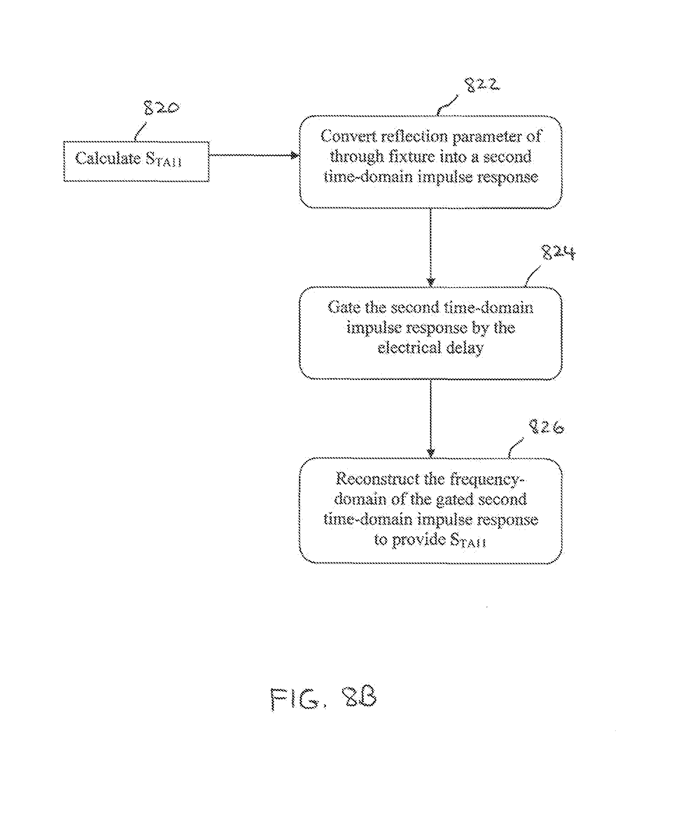

Still referring to FIG. 8A, in step 820, the input reflection parameter of the first through adapter 520 is calculated. Referring to FIG. 8B, in one example, step 820 includes converting the overall input reflection parameter of the through fixture, defined by $S_{T11}$, from the frequency-domain into a second time-domain impulse response (step 822). This conversion may also be accomplished using the above-mentioned chirp z-transform algorithm. In step 824, the second time-domain impulse response is gated by the electrical delay calculated in step 810. To calculate the input reflection parameter of the first through adapter, $S_{TA11}$, the frequency-domain of the gated input reflection parameter is reconstructed from the gated second time-domain impulse response (step 826). The reconstructed frequency-domain corresponds to $S_{TA11}$.

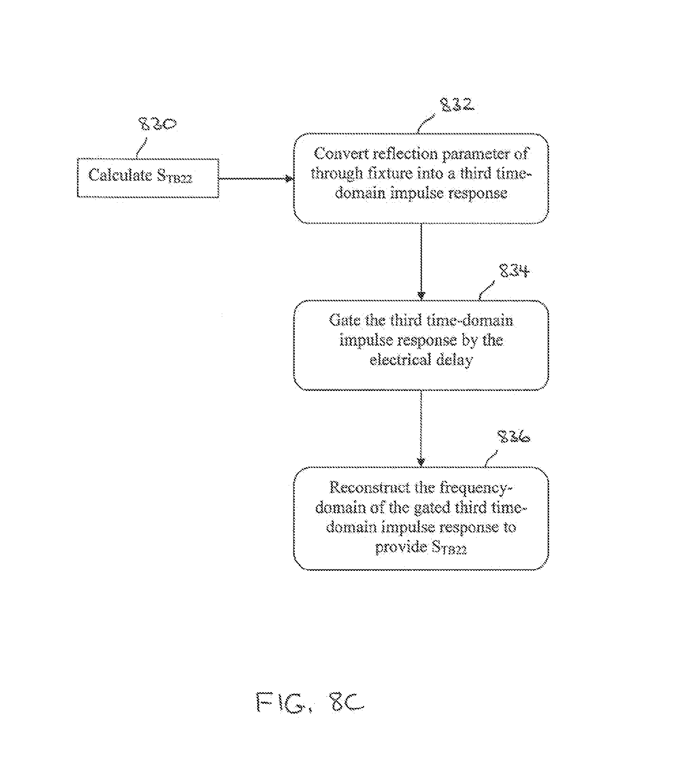

Referring again to FIG. 8A, in step 830 the output reflection parameter of the second through adapter 525 is calculated. Referring to FIG. 8C, in one example, step 830 includes converting the overall output reflection parameter of the through fixture 510, defined by $S_{T22}$, from the frequency-domain into a third time-domain impulse response (step 832). This conversion may also be accomplished using the above-mentioned chirp z-transform algorithm. In step 834, the third time-domain impulse response is gated by the electrical delay calculated in step 810. To calculate the output reflection parameter of the second through adapter, $S_{TB22}$, the frequency-domain of the gated output reflection parameter is reconstructed from the gated third time-domain impulse response (step 836). The reconstructed frequency-domain corresponds to $S_{TB22}$.

Referring again to FIG. 8A, the remaining S-parameters of the two through adapters 520, 525 are calculated (step 840) from the following equations:

$$S_{TA22} = \frac{S_{T22} - S_{TB22}}{S_{T21}} \qquad (4)$$

$$S_{TB11} = \frac{S_{T11} - S_{TA11}}{S_{T21}} \qquad (5)$$

$$S_{TA21} = S_{TA12} = S_{TB21} = S_{TB12} = \sqrt{\frac{S_{T21}^2 - (S_{TA11} - S_{T11})(S_{TB22} - S_{T22})}{S_{T21}}} \qquad (6)$$

Using the above discussed procedure, the through fixture 510 sets up the calibration reference plane for the DUT fixture 110. This reference plane 910 is exactly in the middle of the through fixture 510, as shown in FIG. 9, and is determined during the calibration procedure 230.

According to one embodiment, the DUT fixture 110 is essentially an exact replica of the through fixture 510, except that the transmission line 185 is cut in the middle with respect to the through fixture, at the DUT reference plane 910, and then extended enough in order to accommodate physically the landing of the DUT 140 in the extended area. The DUT leads will cover and extend the DUT reference planes 190a, 190b both at the input and the output locations, and the leads become part of the transmission lines 185. However, the reference planes 190a, 190b are established during the calibration procedure 240. In one example, the physical structure 610 may include one through fixture 510 and several DUT fixtures 110 in order to accommodate different size/shape DUT devices. In addition, the fixture 610 may be designed such that during the actuator pressing of the DUT leads, a repeatable RF connection is made as the DUT is inserted and taken out of fixture. Thus, the DUT fixture may be hardly moved around from insertion to insertion as the fixture's actuator presses against the DUT leads.

Although the device adapters 150, 155 on the DUT fixture 110 may be essentially exact replicas of the through adapters 520, 525 on the through fixture 510, they are physically different devices, and as discussed above, large measurement errors may be introduced for electrically long fixtures. Most of the errors may be introduced from the input reflection parameter $S_{DA11}$ of the first device adapter 150 and the output reflection parameter $S_{DB22}$ of the second device adapter 155 due to reflection differences between the coaxial connectors 530 of the through fixture 510 and the coaxial connectors 180 of the DUT fixture 110. Subscripts "DA" and "DB" refer to the first and second device adapters, respectively. Since there are no coaxial connectors in the middle of fixtures, no error is introduced from the $S_{DA22}$ and $S_{DB11}$ reflections. The present advances in printed circuit board (PCB) technology using advanced materials, such as, for example, Rogers 4000 board material, allow a very uniformed dielectric constant and high frequency performance to be maintained, and allow repeatable characteristics between the through fixture and DUT fixture as far as the transmission line traces (which may be implemented using, for example, microstrip, coplanar waveguide, stripline, or other topologies) are concerned. Therefore, in one embodiment, $S_{TA22}$ of the through fixture 510 is at least substantially equal to $S_{DA22}$ of the DUT fixture 110, and $S_{TB11}$ of the through fixture is at least substantially equal to $S_{DB11}$ of the DUT fixture. Thus, errors can be reduced or even essentially eliminated by accounting for the errors introduced by the different coaxial connectors in the first and second adapters of the through fixture 510 versus the DUT fixture 110. Accordingly, characterizing the device adapters (step 250 in FIG. 2) may determining the correct values of the input reflection parameter $S_{DA11}$ of the first device adapter 150 and the output reflection parameter $S_{DB22}$ of the second device adapter B of the DUT fixture 110 (step 270), as discussed further below.

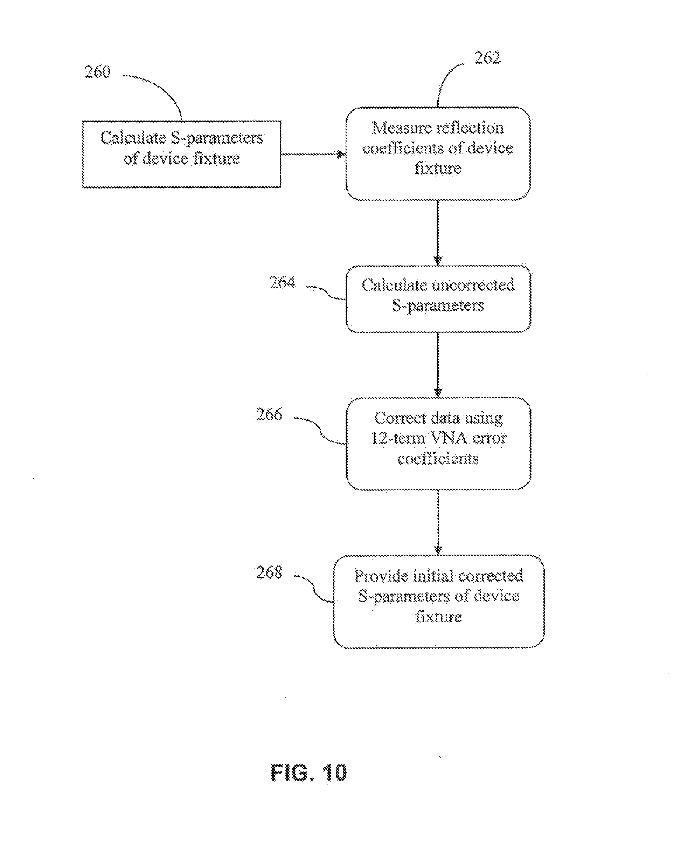

Referring again to FIG. 2, one embodiment of the calibration method includes characterizing the device adapters 150, 155 of the device fixture in step 250 so that the contribution of the device fixture 110 can be removed from measurements of the device fixture, thereby allowing characterization of the device under test alone. According to one embodiment, step 250 includes a step 260 of calculating the S-parameters of the device fixture 110. This step 260 may include connecting one port of the device fixture to a port (e.g., port 120 or 125) of the vector network analyzer 130, connecting known standards 310 (e.g., a short, open and load) to the other port of the device fixture, and measuring the reflection coefficients (step 262, FIG. 10), as discussed above for the through fixture 510 with respect to step 220. The uncorrected S-parameters of the device fixture can be calculated from the measured reflection data using Equations (2) and (3), as discussed above (step 264). This data is corrected in step 266 using the 12-term systematic error coefficients of the vector network analyzer calculated in step 230 discussed above. As a result, initial S-parameters of the overall device fixture 110 (the first device adapter 150 cascaded with the second device adapter 155) can be obtained (step 268).

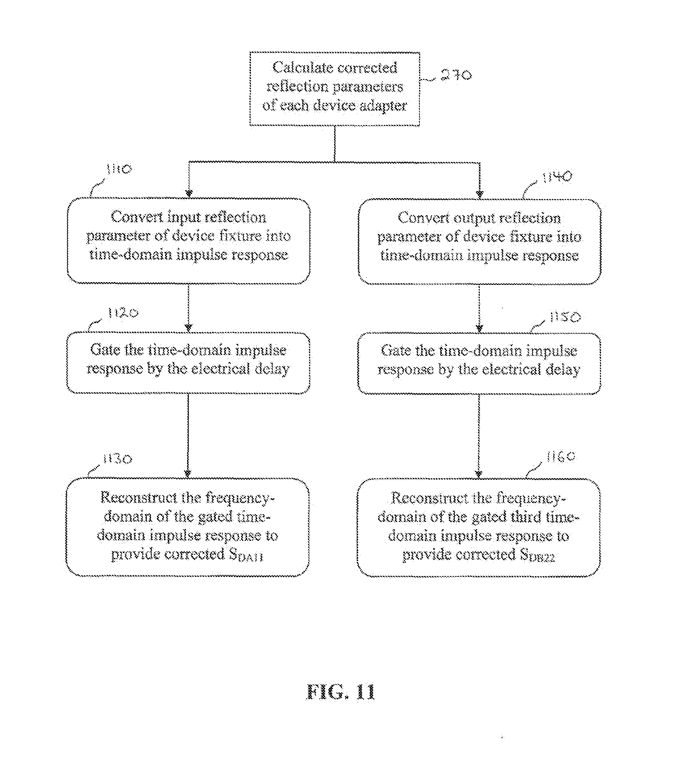

Referring to FIG. 11, to calculate the corrected input reflection parameter $S_{DA11}$ of the first device adapter 150 (step 270), the input reflection parameter $S_{D11}$ of the device fixture (calculated in step 260) is converted from the frequency-domain into a time-domain impulse response (step 1110), as discussed above with respect to the through fixture 510 and step 820 (FIG. 8B). In step 1120, the time-domain impulse response is gated by the electrical delay calculated in step 810 described above. As discussed above, in one embodiment the device fixture 110 is configured as a replica of the through fixture 510, except that the transmission line 185 is cut in the middle with respect to the transmission line 540 of the through fixture 510. As a result, the electrical delay of the device fixture 110 is essentially the same as that of the through fixture 510. Accordingly, the electrical delay calculated for the through fixture 510 in the process discussed above may be used to gate the time-domain responses calculated for the device fixture 110 to determine corrected reflection parameters for the device adapters 150, 155. In step 1130, the frequency-domain of the gated input reflection parameter is reconstructed from the time-domain. The reconstructed frequency-domain is equal to the corrected $S_{DA11}$.

According to one embodiment, step 270 also includes calculating the corrected output reflection parameter $S_{DB22}$ of the second device adapter 155, as illustrated in FIG. 11. Accordingly, in step 1140 the output reflection parameter $S_{D22}$ of the device fixture (calculated in step 260) is converted from the frequency-domain into a time-domain impulse response, using the same procedure discussed above. In step 1150, the resulting time-domain impulse response is gated by the electrical delay calculated in step 810 described above. In step 1160, the frequency-domain of the gated output reflection parameter is reconstructed from the time-domain. The reconstructed frequency-domain is equal to the corrected $S_{DB22}$.

Referring again to FIG. 2, after the corrected reflection parameters $S_{DA11}$ and $S_{DB22}$ have been determined (step 270), complete S-parameters can be calculated for each of the first device adapter 150 and the second device adapter 155 (step 280) using Equations (4)-(6) above and replacing the old values of $S_{TA11}$ and $S_{TB22}$ with the corrected values calculated in step 270. Given calibrated ports of the network vector analyzer (which can be obtained using the process of step 210), embodiments of the above-discussed method including steps 220-280 may be used to characterize the first and second device adapters 150, 155. Once the device adapters 150, 155 have been characterized, the device under test 140 alone can be characterized. According to one embodiment, the S-parameters of the device under test 140 can be determined by de-embedding the first and second device adapters 150, 155 (namely, the S-parameters calculated in step 280) from the measurements obtained of the device fixture in step 260.

Embodiments of the method and apparatus discussed herein provide several advantages and improvements over prior techniques. For example, embodiments of the methods and apparatus are physically better suited for calibration and measurement, and may not require flexible cable for VNA port connectivity. The hardware requirements are far less stringent. For example, to build electrically long adapters in order to be a mirror image of each other, as required by the method discussed in the '918 patent is extremely difficult because it is very difficult to obtain matching reflection parameters between different adaptors. By contrast, the adaptors according to embodiments of the present invention do not require matching reflection parameters, and the transmission parameter between the adapters is easy to match. In addition, major measurement errors are removed by not assuming the characteristic equivalency of adapters between the through configuration and DUT configuration in embodiments of the present methods and apparatus.

Having thus described several aspects of at least one embodiment, it is to be appreciated various alterations, modifications, and improvements will readily occur to those skilled in the art. Such alterations, modifications, and improvements are intended to be part of this disclosure and are intended to be within the scope of the invention. Accordingly, the foregoing description and drawings are by way of example only, and the scope of the invention should be determined from proper construction of the appended claims, and their equivalents.

**Claims**

1. A method of calibrating first and second device adapters, the method comprising:

   connecting a through circuit path to at least a first calibrated coaxial port of a vector network analyzer, the through circuit path comprising a cascaded combination of first and second through adapters;
   calculating first S-parameters of each of the first and second through adapters;
   connecting a measurement circuit path between the first calibrated coaxial port and a second calibrated coaxial port of the vector network analyzer, the measurement path comprising a cascaded combination of a device under test and the first and second device adapters;
   determining second S-parameters of the measurement circuit path; and
   characterizing the first and second device adapters based upon the first and second S-parameters.

2. The method as claimed in claim 1, further comprising, prior to connecting the through circuit path, calibrating first and second coaxial ports of the vector network analyzer to traceable standards to provide the first and second calibrated coaxial ports of the vector network analyzer.

3. The method as claimed in claim 1 or 2, wherein calculating the first S-parameters includes determining overall S-parameters of the through circuit path, including an overall transmission parameter, an overall input reflection parameter, and an overall output reflection parameter.

4. The method as claimed in claim 3, wherein determining the overall S-parameters includes:

   connecting a calibration standard to an output port of the first through adapter; and
   measuring reflection coefficients of the through circuit path.

5. The method as claimed in claim 4, wherein connecting the calibration standard includes connecting at least three calibration standards; and
   wherein measuring the reflection coefficients includes measuring reflection coefficients corresponding to each of the at least three calibration standards.

**6.** The method as claimed in claim 5, wherein connecting the at least three calibration standards includes connecting a short standard, an open standard, and a load standard.

**7.** The method as claimed in any preceeding claim, wherein calculating the first S-parameters further includes determining an electrical delay of the through circuit path.

**8.** The method as claimed in claim 7, wherein determining the electrical delay includes converting the overall transmission parameter from frequency-domain into a time-domain impulse response.

**9.** The method as claimed in claim 7 or 8, further comprising:

converting the overall input reflection parameter from frequency-domain into an input time-domain impulse response;
gating the input time-domain impulse response by the electrical delay;
reconstructing a frequency-domain gated input reflection parameter corresponding to a first input reflection parameter of the first through adapter.

**10.** The method as claimed in claim 7 or 8 or 9, further comprising:

converting the overall output reflection parameter from the frequency-domain into an output time-domain impulse response;
gating the output time-domain impulse response by the electrical delay;
reconstructing a frequency-domain gated output reflection parameter corresponding to a first output reflection parameter of the second through adapter.

**11.** The method as claimed in claim 10, further comprising calculating remaining first S-parameters of the first and second through adapters based on the first input reflection parameter and the first output reflection parameter.

**12.** The method as claimed in claim 1, further comprising:

calculating corrected S-parameters of the measurement circuit path using the first S-parameters; and
based on the corrected S-parameters, determining corrected S-parameters of the first and second device adapters.

**13.** The method as claimed in claim 1, further comprising calibrating first and second coaxial ports of a vector network analyzer to traceable standards.

**14.** The method as claimed in claim 1, further comprising:

calibrating first and second coaxial ports of a vector network analyzer to traceable standards;
determining third S-parameters of the first and second device adapters based upon the first and second S-parameters; and
characterizing the device under test based upon the second and third S-parameters.

**15.** A system for calibrating a device measurement path, the system comprising:

a vector network analyzer having at least a first port and a second port;
a fixture including a through path and the device measurement path, the through path including a cascaded combination of first and second through adapters, and the device measurement path including first and second device adapters and a mounting area disposed between the first and second device adapters and configured to receive a device under test;
wherein the vector network analyzer is configured to measure frequency domain responses of the through measurement path and calculate first S-parameters of each of the first and second through adapters;
wherein the vector network analyzer is configured to measure frequency domain responses of the device measurement path and calculate second S-parameters of the device measurement path; and
wherein the vector network analyzer is further configured to calibrate the device measurement path based on the first and second S-parameters.

**16.** The system as claimed in claim 15, further comprising calibration standards; and wherein the vector network analyzer is further configured to calibrate the first and second ports with the calibration standards.

**17.** The system as claimed in claim 15 or 16, wherein the vector network analyzer is configured to convert the frequency domain responses to corresponding time domain responses to calculate the first and second S-parameters.

**18.** The system as claimed in claim 17, wherein the frequency domain responses of the through circuit include a frequency domain transmission response, a frequency domain input reflection response, and a frequency domain output reflection response; and

wherein the vector network analyzer is further configured to convert the frequency domain transmission response to a time domain transmission response, and to extract an electrical length of the through path from the time domain transmission response.

**19.** The system as claimed in claim 18, wherein the vector network analyzer is further configured to:

convert the frequency domain input reflection response into a time domain input reflection response;
convert the frequency domain output reflection response into a time domain output reflection response;
gate the time domain input and output reflection responses based on the electrical length of the through path;
reconstruct a frequency-domain gated input reflection parameter of the first through adapter; and
reconstruct a frequency-domain gated output reflection parameter of the second through adapter.

Figure 1

Calibrate ports of VNA to known standards — 210

220 — Calculate S-parameters of through fixture → Measure reflection coefficients of through fixture — 225

Determine VNA error coefficients — 230

Calculate S-parameters of each through adapter — 240

250 — Characterize the device adapters → Calculate S-parameters of the overall device fixture — 260

270 — Calculate corrected reflection parameters of each device adapter

280 — Determine corrected S-parameters of each device adapter

290 — Characterize the device under test

FIG. 2

FIG. 3

VNA 130

Port 1 120

Port 2 125

220

Open Short Load 310

370

Coaxial Reference Plane 160

FIG. 4

EP 2 363 719 A1

VNA

130

120
Port 1

125
Port 2

320

160
Coaxial
Reference
plane

510

170

530

Thru

540

Open
Short
Load

310

530

520

525

FIG. 5

FIG. 6

FIG. 7

810

Calculate the electrical
delay of the through fixture

815

Convert transmission parameter
of through fixture into a first
time-domain impulse response

820

Calculate $S_{TA11}$

830

Calculate $S_{TB22}$

240

840

Calculate remaining S-parameters
of each through adapter

FIG. 8A

820

Calculate $S_{TAll}$

822

Convert reflection parameter of through fixture into a second time-domain impulse response

824

Gate the second time-domain impulse response by the electrical delay

826

Reconstruct the frequency-domain of the gated second time-domain impulse response to provide $S_{TAll}$

FIG. 8B

830

Calculate $S_{TB22}$

832

Convert reflection parameter of through fixture into a third time-domain impulse response

834

Gate the third time-domain impulse response by the electrical delay

836

Reconstruct the frequency-domain of the gated third time-domain impulse response to provide $S_{TB22}$

FIG. 8C

FIG. 9

260 — Calculate S-parameters of device fixture

262 — Measure reflection coefficients of device fixture

264 — Calculate uncorrected S-parameters

266 — Correct data using 12-term VNA error coefficients

268 — Provide initial corrected S-parameters of device fixture

FIG. 10

Calculate corrected
reflection parameters
of each device adapter _~270

Convert input reflection
parameter of device fixture into
time-domain impulse response _1110

Convert output reflection
parameter of device fixture into
time-domain impulse response _1140

Gate the time-domain impulse
response by the electrical delay _1120

Gate the time-domain impulse
response by the electrical delay _1150

Reconstruct the frequency-
domain of the gated time-
domain impulse response to
provide corrected $S_{DA11}$ _1130

Reconstruct the frequency-
domain of the gated third time-
domain impulse response to
provide corrected $S_{DB22}$ _1160

FIG. 11

Europäisches
Patentamt

European
Patent Office

Office européen
des brevets

**EUROPEAN SEARCH REPORT**

Application Number

EP 11 15 3600

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MA R ET AL: "Calibrating an Arbitrary Test Fixture for a Symmetric Device by Three Measurements", IEEE TRANSACTIONS ON INSTRUMENTATION AND MEASUREMENT, IEEE SERVICE CENTER, PISCATAWAY, NJ, US, vol. 59, no. 1, 1 January 2010 (2010-01-01), pages 145-152, XP011282253, ISSN: 0018-9456, DOI: DOI:10.1109/TIM.2009.2022111 * abstract; figures 1,2b,3 * * page 145 - page 147 * | 1-3,13, 15-19 | INV. G01R27/32 G01R35/00 |
| X | US 2004/051538 A1 (ADAMIAN VAHE A [US]) 18 March 2004 (2004-03-18) * abstract; figures 1-4,9,10 * * paragraph [0001] - paragraph [0006] * * paragraph [0017] - paragraph [0027] * | 1-19 | |
| X | WO 2008/021885 A2 (TEKTRONIX INC [US]; DOUBRAVA LAUDIE [US]; TAN KAN [US]) 21 February 2008 (2008-02-21) * abstract; figures 1-12 * * paragraph [0002] - paragraph [0006] * * paragraph [0022] - paragraph [0086] * | 1-19 | TECHNICAL FIELDS SEARCHED (IPC) G01R |
| A | US 2006/155498 A1 (DUNSMORE JOEL P [US] ET AL) 13 July 2006 (2006-07-13) * abstract; figures 1,4,5,7-9 * * paragraph [0002] - paragraph [0011] * | 1-19 | |

-/--

The present search report has been drawn up for all claims

| Place of search | Date of completion of the search | Examiner |
|---|---|---|
| Berlin | 6 July 2011 | Ernst, Monika |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt
European
Patent Office
Office européen
des brevets

**EUROPEAN SEARCH REPORT**

Application Number

EP 11 15 3600

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DOLPHIN ABESSOLO-BIDZO ET AL: "Removing S-parameters on-wafer measurements parasitic elements using time domain gating: Application to transmission lines", MICROWAVE CONFERENCE, 2006. APMC 2006. ASIA-PACIFIC, IEEE, PI, 1 December 2006 (2006-12-01), pages 575-578, XP031201551, ISBN: 978-4-902339-08-6 * the whole document * | 1-19 | |
| A | Thomas C. McDERMOTT: "TAPR/Ten-Tec Vector Network Analyzer; Instruction Manual", , 4 February 2007 (2007-02-04), pages 1-59, XP002647723, Retrieved from the Internet: URL:http://www.tapr.org/~n5eg/index_files/ vna_library/VNA_Instruction_Manual_Issue_5 .pdf [retrieved on 2011-07-04] * page 18, paragraph 4.2 * * page 16, paragraph 4 - page 23 * | 1-19 | |
| A | JOEL DUNSMORE ED - DAVID F WAIT: "Calibration for PC Board Fixtures and Probes", ARFTG CONFERENCE DIGEST-SPRING, 19TH ARFTG, IEEE, PI, 1 May 1995 (1995-05-01), pages 56-63, XP031055910, ISBN: 978-0-7803-5686-3 * the whole document * | 1-19 | TECHNICAL FIELDS SEARCHED (IPC) |
| A | US 7 170 297 B1 (DUNSMORE JOEL P [US]) 30 January 2007 (2007-01-30) * abstract; figures 1,2,4A * | 1-19 | |

The present search report has been drawn up for all claims

| Place of search | Date of completion of the search | Examiner |
|---|---|---|
| Berlin | 6 July 2011 | Ernst, Monika |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 11 15 3600

This annex lists the patent family members relating to the patent documents cited in the above-mentioned European search report.
The members are as contained in the European Patent Office EDP file on
The European Patent Office is in no way liable for these particulars which are merely given for the purpose of information.

06-07-2011

| Patent document cited in search report | Publication date | Patent family member(s) | Publication date |
|---|---|---|---|
| US 2004051538 A1 | 18-03-2004 | DE 10338072 A1<br>JP 2004109128 A<br>US 2006181286 A1 | 01-04-2004<br>08-04-2004<br>17-08-2006 |
| WO 2008021885 A2 | 21-02-2008 | NONE | |
| US 2006155498 A1 | 13-07-2006 | NONE | |
| US 7170297 B1 | 30-01-2007 | NONE | |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7157918 B

### Non-patent literature cited in the description

- **DOUGLAS RYTTING.** An Analysis of Vector Measurement Accuracy. *Hewlett-Packard Technical Seminar,* May 1986

- **L.W RABINER ; R. SCHAFER.** The Chirp z-Transform Algorithm. *IEEE Transaction on Audio and Electroacoustics,* June 1969, vol. AU-17 (2